**Europäisches Patentamt**

**European Patent Office**

**Office européen des brevets**

(19)

(11) Veröffentlichungsnummer : **0 354 214 B1**

(12) # EUROPÄISCHE PATENTSCHRIFT

(45) Veröffentlichungstag der Patentschrift :
**09.09.92 Patentblatt 92/37**

(51) Int. Cl.⁵ : **G01R 27/28**

(21) Anmeldenummer : **88903772.7**

(22) Anmeldetag : **05.05.88**

(86) Internationale Anmeldenummer :
**PCT/DE88/00274**

(87) Internationale Veröffentlichungsnummer :
**WO 88/09511 01.12.88 Gazette 88/26**

(54) **VERFAHREN ZUR FESTSTELLUNG DER ELEKTRISCHEN LAUFZEIT VON SIGNALSTRECKEN.**

(30) Priorität : **29.05.87 DE 3718113**

(43) Veröffentlichungstag der Anmeldung :
**14.02.90 Patentblatt 90/07**

(45) Bekanntmachung des Hinweises auf die
Patenterteilung :
**09.09.92 Patentblatt 92/37**

(84) Benannte Vertragsstaaten :
**AT BE CH DE FR GB IT LI LU NL SE**

(56) Entgegenhaltungen :
**DE-A- 2 833 608**
**DE-A-27 523 31**

(56) Entgegenhaltungen :
**Osinga/Maaskant "Handbuch der elektronischen Messgeräte", 1984, S. 273-281**
**IBM Technical Disclosure Bulletin, Vol. 28, Nr.
9 February 1986, Armonk NY (US), "Inferred
on-chip waveform delay measurementtechnique", pages 4048-4049**

(73) Patentinhaber : **SIEMENS
AKTIENGESELLSCHAFT
Wittelsbacherplatz 2
W-8000 München 2 (DE)**

(72) Erfinder : **WELZHOFER, Klaus
Ruffini-Allee 30
W-8032 Graefelfing (DE)**
Erfinder : **VUKSIC, Antun
Otto-Bezold-Weg 18
W-8000 München 83 (DE)**

EP 0 354 214 B1

## Beschreibung

Die Erfindung bezieht sich auf ein Verfahren zur Feststellung der elektrischen Laufzeit von Signalstrecken, die jeweils am einen Ende an einem Anschluß, z. B. für einen integrierten Baustein, angeschlossen sind und die am anderen Ende jeweils einen Sender und einen Empfänger aufweisen.

Ein solches Verfahren ist beispielsweise aus Osinga/Maaskant "Handbuch der elektronischen Meßgeräte", 1984, Seiten 273 bis 281 bekannt, wo Messungen an Übertragungsstrecken nach dem sogenannten "Time-Domain-Reflectometer (TDR)-System" beschrieben sind.

Prüfautomaten dienen dazu, z. B. integrierte Schaltungen auf ihre Fehlerfreiheit zu überprüfen. Dazu weist der Prüfautomat Anschlüsse, z. B. Kontaktelemente, auf, in die der Prüfling hineingesteckt wird. Anschließend werden dem Prüfling Prüfsignale vom Prüfautomaten zugeführt und die daraufhin vom Prüfling abgegebenen Antwortsignale abgenommen und mit Sollsignalen verglichen. Die Übertragung der Prüfsignale und der Antwortsignale erfolgt über Signalstrecken, wobei jeweils eine Signalstrecke einem Anschluß des Prüflings zugeordnet ist. Jede Signalstrecke weist einen Sender zur Erzeugung von Prüfsignalen bzw. einen Empfänger zur Auswertung der Antwortsignale auf. Je nachdem, ob der Anschluß des Prüflings an einer Signalstrecke ein Ausgang oder ein Eingang ist, wird jede Signalstrecke in der einen oder anderen Richtung betrieben.

Beim Prüfautomaten für integrierte Schaltungen müssen an der Anschlußstelle für den Prüfling, auch Prüflingsnahtstelle genannt, im Idealfall sämtliche Signalwege die gleiche elektrische Länge aufweisen, d. h., die bei der Prüfung beteiligten Signalstrecken für den Ansteuerfall (Prüflingseingänge) mit Formatierlogik, Treiber, Kabel usw. oder Empfangsfall (Prüflingsausgänge) mit Kabel, Komparator, Fehlerlogik usw. sollten jeweils dieselbe elektrische Laufzeit aufweisen bzw. unter differenten Lastbedingungen die hierbei auftretende Verfälschung der Treiberimpulsflanken und deren Durchgang durch die Schaltkreisschaltschwelle des Prüflings berücksichtigen. Da die einzelnen Signalstrecken jedoch unterschiedliche Laufzeit haben, müssen die über die Signalstrecken übertragenen Signale korrigiert werden. Dieser Vorgang nennt sich "Deskewing". Diese Korrektur kann über aufwendige externe Meßmethoden durchgeführt werden. Zum Beispiel kann man der Prüflingsnahtstelle Impulse über eine integrierte Relaisschaltmatrix in Verbindung mit Spezialtreibern und Komparatorschaltungen einspeisen oder abnehmen und darüber die Laufzeit der einzelnen Signalstrecke feststellen. Dieses Verfahren ist jedoch aufwendig und berücksichtigt nicht, daß auch die zusätzlich eingefügten Schaltkreise eine Laufzeit haben.

Die der Erfindung zugrundeliegende Aufgabe besteht darin, ein Verfahren anzugeben, bei der ohne großen zusätzlichen Aufwand ein Korrekturwert für den Empfangsfall zur Korrektur der unterschiedlichen Lauf-zeiten von Signalstrecken gewonnen werden kann. Diese Aufgabe wird bei einem Verfahren nach dem Oberbegriff des Patentanspruchs I durch die Merkmale des Kennzeichens des Patentanspruchs I gelöst.

Weiterbildungen der Erfindung ergeben sich aus den Unteransprüchen.

Der Vorteil des erfindungsgemäßen Verfahrens liegt darin, daß als zusätzliches Element nur eine Kurzschlußbrücke erforderlich ist, die anstelle eines Prüflings an der Prüflingsnahtstelle eingesteckt wird. Das zur Messung der Laufzeit verwendete Signal wird dann automatisch mit Hilfe der vorhandenen Signalstrecken, deren Laufzeit nicht überprüft wird, als Zentralimpuls erzeugt, der für alle zu messenden Signalstrecken etwa die gleiche Form hat. Wenn das zeitliche Auftreten des Ausgangssignals des Empfängers in Abhängigkeit des Zentralimpulses festgestellt wird und dieses für alle Signalstrecken, dann ergeben sich Relativwerte, die die unterschiedliche Laufzeit der Übertragung von Signalen von der Anschlußstelle über die Signalstrecken zu den Empfängern kennzeichnen. Durch Nomierung dieser Werte, z.B. auf den kleinsten Wert, kann ein Korrekturfaktor gewonnen werden, der zur Korrektur der Laufzeiten über die Signalstrecken herangezogen werden kann und der dazu führt, daß die elektrischen Verhältnisse auf den verschiedenen Laufzeitstrecken ausgeglichen sind.

Anhand eines Ausführungsbeispiels, das in den Figuren dargestellt ist, wird die Erfindung weiter erläutert. Es zeigen

Fig. I ein Prinzipschaltbild der Signalstrecken, die zu den Anschlußstellen für einen Prüfling führen und deren unterschiedliche Laufzeit festgestellt werden soll,

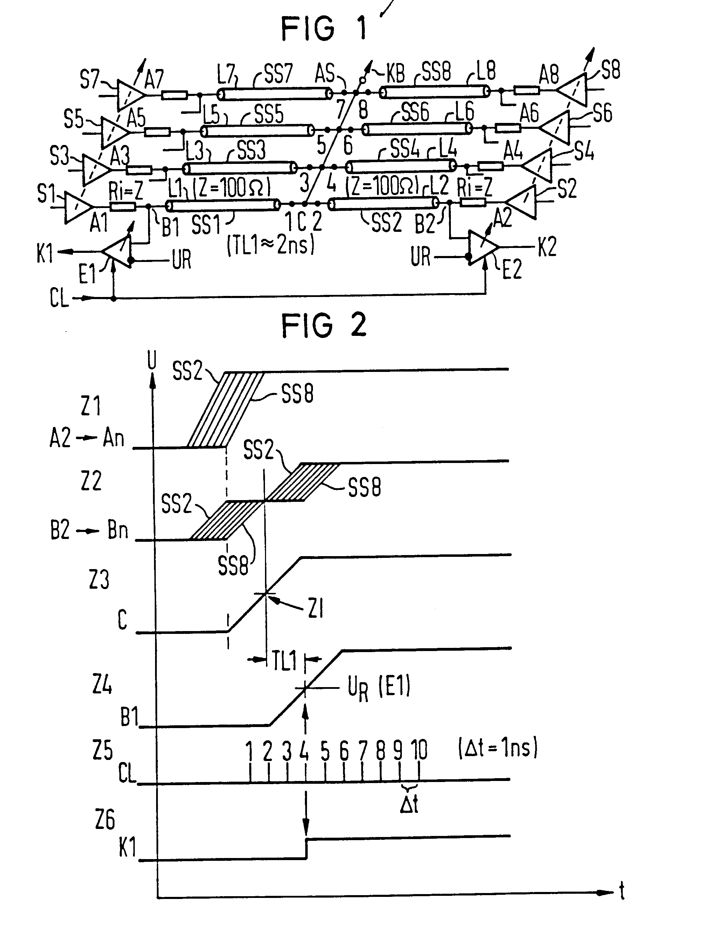

Fig. 2 ein Impulsdiagramm aufgetragen über der Zeit t, anhand dem das Verfahren erläutert wird.

Aus Fig. I ergeben sich z.B. acht Signalstrecken SS, die an Anschlußstellen AS angeschlossen sind. An den Anschlußstellen AS wird z.B. im Prüffall ein Prüfling, z.B. ein integrierter Schaltkreis, eingesteckt. Nach dem Verfahren sind diese Anschlußstellen jedoch über eine Kurzschlußbrücke KB miteinander verbunden. Die Anzahl der Signalstrecken kann in Wirklichkeit sehr viel größer sein, z.B. I024 sein.

Die Signalstrecken können z.B. aus einem Sender S, einer Leitung L, einem Empfänger E bestehen. Der Sender S kann z.B. eine Treiberstufe sein, der Empfänger E eine Komparatorstufe. Am Ausganng des Senders S, vor der Leitung L, kann noch ein Widerstand R eingefügt sein.

Im Prüffall werden über den Sender S Prüfsignale abgegeben, die über die Leitung L an die Anschlußstelle AS übertragen werden und von dort zu einem Prüflingseingang gelangen. Ist eine Anschlußstelle AS mit einem Prüflingsausgang verbunden, dann wird ein vom Prüfling abgegebenes Antwortsignal über die Leitung L zum Empfänger E übertragen, Der Empfänger E bewertet das Antwortsignal mit Hilfe einer Referenzspannung UR und gibt ein entsprechendes Signal K am Ausgang ab. Dieser Betrieb eines Prüfautomat en ist bekannt und braucht deshalb nicht weiter erläutert zu werden.

Um die unterschiedlichen Laufzeiten der einzelnen Signalstrekken SS festzustellen, werden die Anschlußstellen AS für den Prüfling mit Hilfe der Kurzschlußbrücke KB kurzgeschlossen. Dann werden alle Sender S bis auf den Sender der zu messenden Signalstrecke eingeschaltet, alle Empfänger E bis auf den Empfänger der zu messenden Signalstrecke ausgeschaltet. Soll z.B. die Signalstrecke SSI überprüft werden, dann wird der Sender SI dieser Signalstrecke abgeschaltet, der Empfänger EI dieser Signalstrecke eingeschaltet. Die eingeschalteten Sender S der nicht zu messenden Signalstrecken werden dann gleichzeitig aktiviert und geben am Ausgang A einen Sendeimpuls ab. Da die einzelnen Sender S bereits unterschiedliche Laufzeit haben können, erscheinen die Impulse am Ausgang der aktiven Sender S zu verschiedenen Zeitpunkten. Dies ist in der Zeile ZI der Fig.2 angedeutet, z.B. sei die erste Impulsflanke die Impulsflanke, die am Ausgang A2 der Signalstrecke SS2 erscheint. Die letzte Impulsflanke der Zeile ZI sei die Impulsflanke, die am Ausgang A8 der Signalstrecke SS8 erscheint. Das Impulsdiagramm der Zeile ZI ist eine Überlagerung der an den Stellen A der Signalstrecken auftretenden Impulse in ihrer zeitlichen Beziehung zueinander.

An der Stelle B der Signalstrecken SS treten dann die in der Zeile Z2 gezeigten Impulsflanken auf. Im Ausführungsbeispiel besteht an der Stelle B ein Spannungsteiler, der die Amplitude des Impulses der Stelle A halbiert. Wiederum ist der erste Impuls der Impuls an der Stelle B2 der Signalstrecke SS2, der letzte Impuls der Impuls an der Stelle B8 der achten Signalstrecke SS8. Die einzelnen Impulse der verschiedenen Signalstrecken sind wiederum in der Zeile Z2 überlagert dargestellt.

Die Impulsflanke an der Stelle B wird nun über die Leitungen L zum Punkt C, der Anschlußstelle AS übertragen. Nach einer durch die Leitung L festgelegten Laufzeit erscheint die Impulsflanke am Punkt C, wie es in der Fig. 2, Zeile Z3, gezeigt ist. Da die Anschlußstellen AS mit der Kurzschlußbrücke KB kurzgeschlossen sind, überlagern sich die über die Leitungen L übertragenen Impulse zu einem Zentral-impuls ZI, der aus den über die Signalstrecken SS übertragenen Impulsflanken und an der Stelle C reflektierten Impulsflanken aufgebaut ist. Die Form dieses Zentralimpulses ZI ändert sich kaum, wenn andere Signalstrecken gemessen werden, da durch die Vielzahl von Signalstrecken, über die Impulse gesendet werden, Unterschiede in der Laufzeit der einzelnen Signalstrecken ausgeglichen werden.

In Zeile Z2 ist nun weiterhin gezeigt, daß die einzelnen über die Leitungen L übertragenen Impulsflanken an der Stelle C reflektiert werden und zur Stelle B der Signalstrecke zurückübertragen werden. Auf diese Weise wird die Impulsflanke an der Stelle B auf den doppelten Wert angehoben.

Der Zentralimpuls ZI an der Stelle C läuft nun über die Leitung LI der Signalstrecke SS1 weiter und gelangt zum Punkt BI der Signalstrecke SSI nach Verstreichen der Laufzeit TLI der Leitung LI. Dies ist in der Zeile Z4 der Fig. 2 gezeigt. Damit gelangt die Impulsflanke des Zentralimpulses auch zum Empfänger EI. Wenn die Amplitude des Zentralimpulses an dieser Stelle die Referenzspannung UR überschreitet, dann kann der Empfänger E ein Signal abgeben. Der Zeitpunkt des Auftretens dieses Signals wird nun mit Hilfe eines Abtasttaktes CL, der in Zeile Z5 dargestellt ist, festgestellt. Das heißt, am Ausgang des Empfängers EI erscheint dann ein Signal entsprechend Zeile Z6, wenn der Zentralimpuls die Referenzspannung UR überschreitet und gleichzeitig ein Abtasttakt CL anliegt. Im Ausführungsbeispiel der Fig. 4 ist dies z.B. beim Abtasttakt 4 der Fall.

Dieser Wert, z.B. bei SSI der Abtasttakt 4, wird in einer Tabelle gespeichert und ist ein Maß für die Laufzeit eines Impulses von der Stelle C zum Ausgang des Empfängers EI.

Das eben beschriebene Verfahren wird für alle Signalstrecken SS wiederholt, wobei immer die Sender der nicht zu messenden Signalstrecken gleichzeitig aktiv geschaltet werden und nur der Empfänger der zu messenden Signalstrecke eingeschaltet ist. Wenn der Abtasttakt CL im Vergleich zum Zeitpunkt des Aktivschaltens der Sender S immer zum gleichen Zeitpunkt gestartet wird, dann kann für jede Signalstrecke die Anzahl der Abtasttakte bei Auftreten der Impulsflanke des Zentralimpulses ZI am Empfänger der zu messenden Signalstrecke festgestellt werden und dieser Meßwert als Maß der Laufzeit herangezogen werden. Auf diese Weise gewinnt man Relativwerte für die verschiedenen Laufzeiten der Signalstrecken, die ein Kennzeichen für die unterschiedlichen Laufzeiten der Signalstrecken sind. Werden nun diese Meßwerte noch normiert, z.B. auf den kleinsten Meßwert, dann können die über die Signalstrecken übertragenen Signale mit Hilfe dieses normierten Wertes jeder Signalstrecke korrigiert werden.

Wesentlich für das Verfahren ist, daß die Sender gleichzeitig aktiviert werden und daß die Abtasttakte für alle Signalstrekken gleichzeitig eingeschaltet werden. Der Sender der zu messenden Signalstrecke ist hierbei jeweils abgeschaltet oder dient aufgrund seines angepaßten Ausgangswiderstandes (z.B. R an der Stelle A gleich Z) als Abschlußwiderstand für den Wellenleiter der Signalstrecke. Auf diese Weise erhält man für jede Signalstrecke relativ zur Zentralimpulsflanke einen individuellen Meßwert, der z.B. in einer Tabelle hinterlegt werden kann. In einer weiteren Tabelle können dann die Laufzeitunterschiede als Korrekturwerte (Skewwerte) eingetragen werden.

Das beschriebene Laufzeitkorrekturverfahren benötigt für die Kalibrierung eines Testautomaten außer einer Kurzschlußplatine KB keinerlei weitere elektronische Hilfsmittel. Das heißt, sämtliche Kalibriervorgänge können automatenintern durchgeführt werden. Da dieses Korrekturverfahren sämtliche Meßwerte auf den Abtasttakt CL und dessen Feindelayauflösung bezieht, wird die Kalibrierung umso genauer, je linearer der Abtasttakt und je feinstufiger seine Delayauflösung ist. Selbstverständlich kann dieses Verfahren auch zur Erfassung und Kalibrierung anderer automateninterner Signale verwendet werden, sofern diese über die Anschlußstellen AS zugänglich sind.

Auch die Generierung der Zentralimpulsflanke durch die an den Anschlußstellen AS kurzgeschlossenen und parallel angesteuerten Sender bereitet wenig Probleme, da der Innenwiderstand dieser Impulsflanke aus n parallelgeschalteten Signalstrecken besteht. Zum Beispiel sei der Wellenwiderstand einer Signalstrecke R = $100\Omega$ , dann beträgt der Innenwiderstand bei z.B. 100 parallel geschalteten Sendestrecken $100\,\Omega : 100 = 1\,\Omega$ , wodurch ein Skewfehler eines einzelnen Senders von z.B. 2 ns sich nur mit 2 ns : 100 = 20 ps bemerkbar macht. Die absolute Lage der Zentralimpulsflanke ist bei diesem Verfahren nicht relevant. Eine Anordnung zur Erzeugung der Abtasttakte ist nicht dargestellt worden, solche Anordnungen sind bekannt und sind in Prüfautomaten in der Regel vorhanden.

**Patentansprüche**

l. Verfahren zur Feststellung der elektrischen Laufzett von Signalstrecken, die jeweils am einen Ende an einer Anschlußstelle angeschlossen sind und die am anderen Ende jeweils einen Sender und einen Empfänger aufweisen, **gekennzeichnet** durch folgende Schritte:
a) die Anschlußstellen (AS) aller Signalstrecken (SS) werden kurzgeschlossen,
b) alle Empfänger (E) bis auf den Empfänger der zu messenden Signalstrecke werden abgeschaltet,
c) alle Sender (S) bis auf den Sender der zu messenden Signalstrecke werden eingeschaltet und geben gleichzeitig jeweils einen Sendeimpuls ab, der zur zugehörigen Anschlußstelle übertragen wird,
d) an den kurzgeschlossenen Anschlußstellen (AS) überlagern sich die Sendeimpulse zu einem Zentralimpuls (ZI), der über die zu messende Signalstrecke zu dem zugehörigen Empfänger übertragen wird,
e) der Zeitpunkt des Auftretens eines vom Zentralimpuls ausgelösten Impulses am Ausgang des Empfängers der zu messenden Signalstrecke wird festgestellt und als die Laufzeit kennzeichnender Meßwert in einer Tabelle eingetragen,
f) die Schritte a) bis e) werden für alle Signalstrecken (SS) durchgeführt.

2. Verfahren nach Anspruch l, dadurch **gekennzeichnet**, daß die in der Tabelle gespeicherten Meßwerte normiert werden, wobei die Werte auf den kleinsten Wert bezogen werden.

3. Verfahren nach Anspruch l oder 2, dadurch **gekennzeichnet**, daß der Zeitpunkt des Auftretens des Zentralimpulses (ZI) am Empfänger der zu messenden Signalstrecke mit Hilfe von Abtasttakten (CL) festgestellt wird, die zu einem festgelegten Zeitpunkt im Vergleich zum Auslösen der Sendeimpulse gestartet werden und deren Anzahl bis zur Beeinflussung des Senders durch den Zentralimpuls (ZI) gezählt werden.

4. Verfahren nach einem der vorhergehenden Ansprüche, dadurch **gekennzeichnet**, daß der Empfänger (E) ein Komparator ist, der den Ausgangsimpuls dann abgibt, wenn der durch den Zentralimpuls (Zi) ausgelöste Impuls einen Referenzwert (UR) überschreitet und ein Abtasttakt (CL) anliegt.

5. Verfahren nach einem der vorhergehenden Ansprüche, dadurch **gekennzeichnet**, daß jede Signalstrecke einen sender (S), eine an dessen Ausgang angeschlossene Leitung (L) und einem zwischen Sender (S) und Leitungg (L) angeschlossenen Empfänger (E) aufweist, wobei das freie Ende der Leitung (L) die Anschlußstelle (AS) bildet.

6. Verfahren nach einem der vorhergehenden Ansprüche, dadurch **gekennzeichnet**, daß die Signalstrecken (SS) den Empfangssignalweg vom Prüfstift eines Prüfautomaten bilden.

**Claims**

1. Method for determining the electrical duration of signal paths, which are connected at one end to a connecting point in each case and have at the other end a transmitter and a receiver in each case, characterised by the following steps:
a) the connecting points (AS) of all signal paths (SS) are short-circuited,
b) all receivers (E) except for the receiver of the signal path to the measured are turned off,

c) all transmitters (S) except for the transmitter of the signal path to be measured are turned on and in each case simultaneously output a transmit pulse which is transmitted to the associated connecting point,

d) the transmit pulses are superposed at the short-circuited connecting points (AS) to form a central pulse (ZI) which is transmitted to the associated receiver over the signal path to be measured,

e) the time of occurrence of a pulse triggered by the central pulze at the output of the receiver of the signal path to be measured is determined and is entered in a table as measured value characterising the duration, and

f) the steps a) to e) are carried out for all signal paths (SS).

2. Method according to Claim 1, characterised in that the measured values stored in the table are normalised, the values being related to the lowest value.

3. Method according to Claim 1 or 2, characterised in that the time of occurrence of the central pulse (ZI) at the receiver of the signal path to be measured is determined with the aid of strobe pulses (CL) which are started at a defined time in comparison with the triggering of the transmit pulses, and the number of which are counted until the transmitter is influenced by the central pulse (ZI).

4. Method according to one of the preceding claims, characterised in that the receiver (E) is a comparator which outputs the output pulse whenever the pulse triggered by the central pulse (ZI) exceeds a reference value (UR) and a strobe pulse (CL) is present.

5. Method according to one of the preceding claims, characterised in that each signal path has a transmitter (S), a line (L) connected to the output thereof, and a receiver (E) connected between transmitter (S) and line (L), the free end of the line (L) forming the connecting point (AS).

6. Method according to one of the preceding claims, characterised in that the signal paths (SS) form the receive signal path from the test pin of an automatic tester.

**Revendications**

1. Procédé pour déterminer le temps de propagation électrique dans des sections de transmission de signaux, dont une extrémité est raccordée respectivement à un point de raccordement et dont l'autre extrémité comporte respectivement un émetteur et un récepteur, caractérisé par les étapes suivantes :

a) on court-circuite les points de raccordement (AS) de toutes les sections (SS) de transmission de signaux,

b) on débranche tous les récepteurs (E) hormis le récepteur de la section de transmission de signaux à mesurer,

c) on branche tous les émetteurs (S) hormis l'émetteur de la section de transmission de signaux à mesurer et tous les émetteurs délivrent simultanément respectivement une impulsion d'émission qui est envoyée au point de raccordement associé,

d) au niveau des points de raccordement (AS) court-circuités, les impulsions d'émission se superposent pour former une impulsion centrale (ZI), qui est transmise au récepteur associé par l'intermédiaire de la section de transmission de signaux à mesurer,

e) l'instant d'apparition d'une impulsion déclenchée par l'impulsion centrale, à la sortie du récepteur de la section de transmission de signaux à mesurer est déterminé et est introduit dans un tableau en tant que valeur de mesure caractérisant le temps de propagation,

f) les étapes a) à e) sont exécutées pour toutes les sections de transmission de signaux (SS).

2. Procédé suivant la revendication 1, caractérisé par le fait que les valeurs de mesure mémorisées dans le tableau sont normalisées, ces valeurs étant rapportées à la valeur minimale.

3. Procédé suivant la revendication 1 ou 2, caractérisé par le fait que l'instant d'apparition de l'impulsion centrale (ZI) dans le récepteur de la section de transmission de signaux à mesurer est déterminé à l'aide d'impulsions de cadence d'échantillonnage (CL), qui sont déclenchées à un instant fixé par rapport au déclenchement des impulsions d'émission et dont le nombre est compté jusqu'à ce que l'impulsion centrale (ZI) influence l'émetteur.

4. Procédé suivant l'une des revendications précédentes, caractérisé par le fait que le récepteur (E) est un comparateur, qui délivre l'impulsion de sortie lorsque l'impulsion déclenchée par l'impulsion centrale (ZI) dépasse une valeur de référence (UR) et qu'une impulsion de cadence d'échantillonnage (CL) est présente.

5. Procédé suivant l'une des revendications précédentes, caractérisé par le fait que chaque section de transmission de signaux comporte un émetteur (S), une ligne (L) raccordée à sa sortie et un récepteur (E) raccordé entre l'émetteur (S) et la ligne (L), l'extrémité libre de la ligne (L) formant le point de raccordement (AS).

6. Procédé suivant l'une des revendications précédentes, caractérisé par le fait que les sections (SS) de transmission de signaux forment la voie de transmission de signaux de réception partant de la tige de contrôle d'un automate de contrôle.

# FIG 1

# FIG 2